# EUROPEAN PATENT SPECIFICATION

(11) **EP 1 408 015 B1**
(45) Date of publication and mention of the grant of the patent: **10.12.2008**
(21) Application number: 03022667.4
(22) Date of filing: 07.10.2003
(51) Int. Cl.: C03C 17/04, C03C 17/02, C03B 32/02, C30B 15/10, C30B 35/00

(54) **Quartz glass crucible, its process of manufacture and use**
Quarzglastiegel, sein Herstellungsverfahren und seine Verwendung
Creuset en verre de silice, son procédé de fabrication et son ultilisation

(30) Priority: 09.10.2002 JP 2002295832
(43) Date of publication of application: 14.04.2004
(60) Divisional application: 08012141.1
(73) Proprietor: Japan Super Quartz Corporation, Akita city Akita 010-0065 (JP)
(72) Inventor: Tsujimoto, Toshio, R&D Center, Akita-shi AKita 010-0065 (JP); Ishizuka, Hiroya, R&D Center, Akita-shi AKita 010-0065 (JP); Fumoto, Naotaka, Japan Super Quartz Corporation, Shiyoda-ku Tokyo 100-005 (JP)
(74) Representative: HOFFMANN EITLE

(56) References cited:
- EP-A- 0 911 429
- WO-A-02/40732
- GB-A- 1 255 551
- US-A- 5 389 582
- PATENT ABSTRACTS OF JAPAN vol. 2003, no. 07, 3 July 2003 (2003-07-03) & JP 2003 073183 A (MITSUI MINING & SMELTING CO LTD), 12 March 2003 (2003-03-12)

## Description

### BACKGROUND OF THE INVENTION

### FIELD OF THE INVENTION

The present invention relates to a reinforcing process of a silica glass crucible used for pulling a silicon single crystal for a semiconductor.

### DISCUSSION OF THE BACKGROUND

Silica glass crucibles used for pulling the silicon single crystal are used under high temperature of more than 1000 degree C. When the temperature becomes over 1200 degree C, the viscosity of the silica glass is decreased, and deformation is a problem. Since the crucible is used at a temperature of more than a melting point of silicon, i.e., 1410 degree C, the crucible is used by being held in a carbon susceptor, in order to keep the form of the crucible. Recently, the large size silica crucible having the diameter of more than 28 inches, i.e., 700mm, has been used in accordance with increasing a diameter of a silicon wafer, and the pulling time becomes long with increasing the charging amount of a silicon metal in the crucible, so that the crucible becomes to receive a higher thermal load. As the result, there is a problem that the crucible is deformed, that is, for example, a side wall of the crucible is fallen down to the inside in the carbon susceptor, or the crucible is sagged by own weight. When the crucible is deformed greatly during the pulling of the silicon single crystal, the pulling must be stopped, so that the big cost loss is occurred.

As for the prior art of such process reinforcing the silica glass substance, the process has been known, in which said substance is reinforced by doping an impurity to the silica glass to increase the viscosity of the glass or by crystallizing the silica glass with a crystallization promoter, such as barium etc., (Japanese Patent Laid Open No. Hei 8 - 2932 and No. Hei 9-110590). However, in these processes, since the impurity is used, there is a problem in the semiconductor field, where the use of the impurity is disliked extremely. On the other hand, it has been proposed that the technology, in which a quartz crystalline particle is embedded in the surface of the silica glass crucible, and the adhered particle is used as a nucleus to crystallize the silica glass at the time of melting the poly-crystalline silicon under the high temperature (Japanese Patent Laid Open No. 2000 - 169283), instead of the method using the impurity. As for this technology, although it is possible to avoid the contaminant of the impurity by using the quartz particle, there is a problem that since an amorphous phase exists between the quartz crystal particles, a part of the crystal layer becomes to be released easily by the difference of thermal expansion coefficients in accordance with progressing the around crystallization. Furthermore, the crystal layer becomes un-uniform easily.

GB-A-1 255 551 teaches a method of reinforcing a fused silica tube by spraying a fine crystalline material such as Cristobalite in powder form onto the tube and then heating it by flame or in a furnace to form a coherent layer of Cristobalite.

WO 02/40732 teaches a method of protecting a quartz crucible by depositing from a plasma jet a powder of a material selected from oxides of alkaline earth elements, oxides of transition metals, lanthanide sesquioxides, aluminium oxide or binary, tertiary or quaternary metal oxides.

### SUMMARY OF THE INVENTION

The present invention solves the above-described problems, and has an object to provide a technology, in which the surface of the quartz glass crucible is crystallized effectively and uniformly to be reinforced without inducing the impurity into the the silica glass crucible.

In the present invention, as for the silica glass substance or the silica glass crucible, the following reinforcing technologies are provided.

According to a first aspect, the present invention provides a process for reinforcing a silica glass crucible comprising the steps of:
forming on the whole or a part of a surface of the silica glass crucible a layer of silica glass powder comprising fine and course silica particles, wherein more than 20 weight % of all powder is the fine silica particles having a particle size of less than 10 µm, and the remaining powder is the coarse silica particles having a particle size of less than 150 µm, and
crystallising the silica glass powder layer on the surface of the crucible at high temperature to reinforce the silica glass crucible.

Preferably, the high temperature corresponds to the melting temperature of silicon raw material charged into the silica glass crucible.

It is further preferred that the layer of silica glass powder is a porous layer formed on the surface of the silica glass crucible by heating and sintering the silica glass powder at a temperature below the crystallisation temperature.

It is preferred that the silica glass powder layer is formed by:
(i) forming a slurry comprising silica glass powder and optionally a binder,
(ii) coating said slurry on the surface of the silica glass crucible, and
(iii) solidifying the coated slurry.

According to a second aspect, the present invention provides a method for pulling a silicon single crystal comprising the steps of:
forming a silica glass powder layer on the whole or a part of the surface of a silica glass crucible, the silica glass powder comprising fine and coarse silica particles, wherein more than 20 weight % of all powder is the fine silica particles having a particle size of less than 10 µm, and the remaining powder is the coarse silica particles having a particle size of less than 150 µm, and
crystallising the silica glass powder layer on the surface of the crucible at high temperature at the time of melting the silicon raw material charged into the crucible to reinforce the silica glass crucible.

### DETAILED DESCRIPTION OF THE PREFERRED EMBODIMENTS

The present invention provides a method for reinforcing a quartz glass crucible. It includes the steps of forming a silica glass powder layer on the whole or a part of the surface of a silica glass crucible, and baking and crystallizing the silica glass powder on the surface of the crucible at high temperature during the pulling process.

In the present invention, the silica glass powder is used as a material promoting the crystallisation on the surface of the quartz glass crucible. When the quartz glass is made into the fine powder, the surface energy of the powder becomes high, and it is easy to crystallize rather than a bulky silica glass. When the temperature is raised to about 1000 degree C, the silica glass powder layer begins to sinter to form a porous glass layer and a firmly adhering layer is deposited on the surface of the silica glass. Furthermore, when the temperature is raised to about 1300 degree C, since the crystallization is progressed from the surface of the porous layer, the crystallization speed of the porous layer is faster than the bulky silica substance. Since said porous glass layer is crystallized, the reinforcement of the quartz glass crucible is increased, so that it is possible to prevent the deformation under the high temperature. When the time for keeping the high temperature becomes long, the silica glass crucible becomes to be crystallized itself, so that the reinforcement is increased further.

In addition, as described above, it has been already known that the method, in which the crystalline quartz particles are embedded in the surface of the glass crucible to be used as a nucleus to crystallize around amorphous glass phase at the time of the heating. However, in this method, there are problems that the quartz particles are released from the surface of the crucible because the thermal expansion coefficient of the quartz is different from that of silica glass, especially the phase transition from α-quartz to β-quartz occurs at 573 degree C arises serious problem. When the silica glass powder is used, there are no such problems, and the uniform crystal phase can be given.

As for the fine quartz glass powder layer, the silica glass powder layer comprises fine and coarse silica particles, wherein more than 20 weight % of all powder are the fine silica particles having smaller particle size than 10µm, and remaining powder are the coarse silica particles having less than 150 µm. Since the powder having the particle size of more than 150µm is hard to be crystallized, it is not preferable. The powder having the particle size of less than 150µm is easy to be crystallized, and more than 20 weight % of the powder having the particle size of less than 10µm is more preferable. Moreover, said silica glass powder layer comprises the coarse and fine particles. The quartz glass powder is shrunk at the time of the sintering in general. However, as for the quartz glass powder layer comprising the coarse and fine particles, since the shrinkage percentage can be controlled to several %, it is possible to form the uniform crystal phase having no crack. On the other hand, when the silica glass powder layer is formed by the powder having narrow particle size distribution, that is, the almost particle has the same size even when the particle size is less than 10µm, cracks are aroused because said silica glass powder layer is shrunk more than 10% by sintering under the high temperature, so that the strength is lower even when the layer is crystallized.

The method for forming the silica glass powder layer is not limited. For example, it is available that a slurry comprising the silica glass powder and water is coated on the surface of the silica glass substance or the silica glass crucible to be dried. In order that said silica powder layer is not released when the crucible is carried or set in a furnace of puller, it is preferable that the silica glass powder layer on the surface of the crucible is sintered under the lower temperature than the crystallization temperature to be the porous glass layer. Since the porous glass layer is baked on the surface of the crucible by sintering, the glass layer becomes hard to be released. It is preferable that the sintering temperature is from more than 1000 degree C to less than 1300 degree C, more preferably about 1200 degree C. As for the silica glass crucible having the porous glass layer, the crystallization is progressed from said porous layer by heating under the high temperature at the pulling process of the silicon single crystal, and reinforces the crucible.

As the other method for forming the silica glass powder layer, it is also available that a binder is added to the slurry containing the silica glass powder, and said slurry is coated on the surface of the silica glass substance to be reinforced to form the silica glass powder layer. It is preferable that the binder is an organic substance, such as acrylics or vinyl acetate etc., which can be vaporized during the temperature-raising in a furnace of puller. It is possible to carry out the coating easily by adding the binder to increase a tackiness of the slurry. The silica glass powder layer formed on a silica glass crucible by these method, is sintered to be the porous layer by heating under the high temperature at the pulling process of the silicon single crystal, and the crystallization begins and progresses from said porous layer.
In addition, as the binder, it is available that the partial hydrolyzate of an alkoxysilane oligomer is used. In this case, after forming the silica glass powder layer, it is available that the solution containing the partial hydrolyzate of the alkoxysilane oligomer is sprayed on said layer and is baked at from 100 degree C to 500 degree C. Siliceous materials formed from alkoxysilane prevent the releasing of the silica glass powder layer.

In this case, the partial hydrolyzate of an alkoxysilane oligomer used in the present invention is obtained by a process in which the alkoxysilane oligomer is hydrolyzed under the controlled reaction conditions, and after the alcohol is removed, each generated OH group is bonded together to form the silica sol. As a suitable starting material, one or more silane compounds having at least one, preferably more than two, and more preferably more than three alkoxyl groups, can be used. Concretely, tetraethoxysilane (= ethylsilicate), tetrapropoxysilane, methyltriethoxysilane, dimethylmethoxysilane, phenyltriethoxysilane, chlorotrimethylsilane, various kinds of silane coupling reagents, such as vinyltriethoxysilane, γ-aminopropyltriethoxysilane, etc., also can be mentioned. Ethylsilicate, which is the cheapest and to be easily hydrolyzed, is preferred.

These alkoxysilanes are used as the hydrolyzate, which is partially hydrolyzed beforehand. The partial hydrolysis is carried out in the presence of an acid catalyst, i.e., an inorganic acid, such as hydrochloric acid, or an organic acid, such as p-toluene sulfonic acid, and water. Then, the reaction conditions, including, whether using the acid catalyst or not, the amount of acid catalyst, the amount of the water for hydrolysis in the reaction system, the reaction temperature and the reaction time, are adjusted to obtain the partial hydrolyzate of alkoxysilane oligomer.

In the case of any above-described methods, the silica glass powder layer is formed preferably by that the slurry, in which more than 20 weight % of all powder comprises the silica particle having the particle size of less than 10 µm, is coated on the surface of the silica substance or the crucible in the concentration of more than 1 mg / cm² if changed into silica glass, it is suitable that the thickness of the coated silica glass powder layer is more than 0.1mm. When the thickness is thinner than 0.1mm, the strength is not enough to prevent the deformation of the silica substance.

When the silica glass crucible is reinforced by forming the silica glass powder layer, it is available that the silica glass powder layer is formed on the outside surface of the crucible. As for an adhesion range of the silica glass powder layer, it is available that said layer is formed on the whole or a part of the outside surface of the crucible. When the silica glass powder layer is formed on a part of the crucible, it is available that said layer is formed in the ring configuration so as to go around the periphery of the crucible or in the other configuration. In addition, when said layer is formed on the inside surface of the crucible, it is available that said layer is formed in the ring configuration around the inner circumference on an upper end portion not contacted with a molten silicon held in the crucible.

As for the conventional silica glass substance, after forming the fine quartz glass powder layer, the formed silica glass powder layer is crystallized under the high temperature to reinforce the silica glass substance. As for the conventional silica glass crucible, the silica glass powder on the surface of the crucible is crystallized by heating under the high temperature at the melting of the silicon raw material being charged into the crucible having the silica glass powder layer on the whole or a part of the surface of the crucible. In this way, the crystallization of the surface of the crucible is carried out at the melting of the silicon raw material. In the case that the surface of the crucible is crystallized before setting in the puller, the crystal is abraded by the difference of the thermal expansion coefficients between the crystal phases and the glass phases, and the phase transformation from α to β phase when the temperature is increasing.

The silica glass crucible is reinforced by the above-described crystallization of the silica glass powder and its deformation is prevented under the high temperature. According to the above-described reinforcing process, it is not necessary to use the impurity, and the impurity is not intermixed since the fine quartz glass powder is crystallized by using the property of said powder itself. So, said reinforcing process is suitable in the production of a high purity material, such as the silicon single crystal by the pulling method. More particularly, in pulling of the silicon single crystal, the high purity silicon single crystal, in which the impurity is not intermixed, can be pulled, by using the silica glass crucible having the fine quartz glass powder layer on the whole or a part of the surface of the crucible, and crystallizing the silica glass powder on the surface of the crucible under the high temperature at the time of melting the silicon raw material being charged into said crucible, to reinforced said crucible.

### EXAMPLES

Hereinafter, the present invention is further explained by way of the examples.

### Example 1

As for the piece of the silica glass, which has the width of 2 cm, the length of 9 cm, and the thickness of 1 cm, a bending test by the own weight was carried out while supporting said piece at two points. The distance between the two points was 7 cm. The temperature was 1500 degree C, and the keeping time was 10 hours, and the temperature-raising time was 2 hours. The dropped depth of the central portion was measured, and the deformation at the time of the high temperature was evaluated. These results were shown in Table 1.

**[Table 1]**

| | Sample 1 | Sample 2 | Sample 3 | Sample 4 | Sample 5 | Sample 6 |
|---|---|---|---|---|---|---|
| Deformation Amount (mm) | 9 | 5 | 3 | 16 | 17 | 17 |

[Sample 1] A fine spherical silica powder being produced by FUSO CHEMICAL CO., LTD., was used as the fine quartz glass powder. As for the impurities, an alkali metal was less than 1 ppm, and a heavy metal was less than 0.1 ppm. The slurry was prepared, by mixing 4.5g of the glass powder having the average particle size of 7µm, 0.5g of the glass powder having the average particle size of 1µm, and 0.25g of the glass powder having the average particle size of 0.3µm, and adding an ultra pure water to the mixed powder. The prepared slurry was coated on the one side of the piece of the quartz glass with 0.5 mm of the layer thickness.

[Sample 2] The slurry was prepared by pulverizing a high purity synthetic silica powder having the average particle size of 230µm, which was used as the raw material of the crucible, by a ball mill. First, 2.3kg of the synthetic silica powder, 6.8kg of high purity silica balls having the diameter of 10 mm, and 765g of the ultra pure water were taken into a nylon pot to be pulverized for 40 hours. The obtained glass powder is the mixed powder consisting of the fine particle having the particle size of less than 10µm of 58 weight % and the coarse particle having the particle size larger than 10µm of 42 weight %. As for the amount of the impurities in the obtained glass powder, the alkali metals and the other heavy metals were less than 1 ppm. The prepared slurry was coated on the one side of the piece of the quartz glass with 0.5 mm of the layer thickness.

[Sample 3] The slurry was prepared by pulverizing a high purity synthetic silica powder having the average particle size of 230µm, which was used as the raw material of the crucible, by a ball mill. First, 1kg of the synthetic silica powder, 4.3kg of high purity alumina balls having the diameter of 5 mm, and 333g of the ultra pure water were taken into a high purity alumina pot to be pulverized for 30 hours. The given glass powder is the mixed powder consisting of the fine particle having the particle size of less than 10µm of 68 weight % and the coarse particle having the particle size larger than 10µm of 22 weight %. As for the amount of the impurities in the given glass powder, Al was 500 ppm, and the alkali metals and the other heavy metals were less than 1 ppm. The prepared slurry was coated on the one side of the piece of the quartz glass with 0.5 mm of the layer thickness.

[Sample 4] As the comparison reference, the slurry was prepared by pulverizing a crystalline natural quartz powder being used as the raw material of the crucible by the ball mill. First, 1kg of the natural quartz powder, 4.3kg of the high purity alumina balls having the diameter of 5 mm, and 333g of the ultra pure water were taken into the high purity alumina pot to be pulverized for 30 hours. In the given glass powder, the fine particle having the particle size of more than 10µm was 55 weight %. As for the amount of the impurities in the given glass powder, Al was 550 ppm, and the alkali metals and the other heavy metals were less than 3 ppm. The prepared slurry was coated on the one side of the piece of the silica glass with 0.5 mm of the layer thickness.

[Sample 5] As the comparison reference, the slurry was prepared by adding 4g of the ultra pure water to 5.25g of the fine spherical silica powder having the average particle size of 1µm, which was the fine silica powder having the same particle size. The prepared slurry was coated on the one side of the piece of the silica glass with 0.5 mm of the layer thickness.

[Sample 6] As the comparison reference, the sample being not coated was tested.

As for the samples 1, 2 and 3, in which the silica glass powder was coated according to the present invention, the deformation amounts were remarkably small. After testing, it was confirmed by X-ray diffraction analysis that the coated layers of the samples 1, 2 and 3 were the crystal layers of cristobalite.

As the reason why the deformation amount of the sample 2 was smaller than said amount of the sample 1, it was considered that the crystallization was more enhanced with strain generated in the glass powder when the silica glass was pulverized.

As the reason why the deformation amount of the sample 3 was smaller than said amount of the sample 1, it was considered that the crystallization was more enhanced with aluminum being intermixed and strain generated in the glass powder when the silica glass was pulverized. As the reason why the deformation amount of the sample 3 was smaller than said amount of the sample 2, it was considered that the crystallization was more enhanced with intermixed aluminum when the silica glass was pulverized by alumina balls.

As for the sample 4, in which the crystalline quartz powder was used, there was almost no effect for reinforcing the glass substance. When the sample 4 was rubbed after testing, the coated layer was abraded easily. The reason why said layer was abraded easily was that said layer was not sintered at the time of the heating since the crystalline quartz powder was used.

As for the sample 5, in which the fine particle having the same particle diameter was used, there was also no effect. It was observed that the sample 5 after the test had a countless crack. Although, the cristobalite crystal was confirmed in the coated layer by the X-ray diffraction analysis, the reason of no effect is considered that the sample 5 was deformed since the strength was not increased by the cracks.

### Example 2

The same slurry of the silica glass powder as the sample 3 of Example 1 was coated on the outside surface of quartz glass crucible for pulling the semiconductor, and the coated slurry was heated under the temperature of 1200 degree C, in which said slurry was not crystallized, to bake the coated layer. When the layer after the baking was rubbed, said layer was not abraded, and adhered to the crucible strongly. Moreover, said crucible was washed with a hydrochloric acid. By using said crucible, the pulling test of the silicon single crystal was carried out, wherein a multi-pulling test, in which the silicon single crystal was pulled 4 times, was carried out. As the comparison reference, the same pulling test was carried out to the crucible being not formed with the above-described coated layer. Each said pulling test was carried out by using 5 crucibles. As the result, as for the comparison sample, 4 crucibles were deformed, so that said pulling test had to be stopped during the test. On the other hand, as for the crucible of the present invention, all 5 crucibles were not deformed.

According to the present invention, the silica glass substance or the silica glass crucible is reinforced by the crystallization of the silica glass powder and the deformation under the high temperature is prevented. As for the process of the present invention, since the silica glass crucible was crystallized by using the property of the silica glass powder, the impurity is not intermixed. So, said process is suitable to the production of the high purity material, such as the silicon single crystal by the pulling method.

## Claims

1. A process for reinforcing a silica glass crucible comprising the steps of:
forming on the whole or a part of a surface of the silica glass crucible a layer of silica glass powder comprising fine and coarse silica particles, wherein more than 20 weight % of all powder is the fine silica particles having a particle size of less than 10 µm, and the remaining powder is the coarse silica particles having a particle size of less than 150 µm, and
crystallising the silica glass powder layer on the surface of the crucible at high temperature to reinforce the silica glass crucible.

2. A process according to Claim 1, wherein the high temperature corresponds to the melting temperature of silicon raw material charged into the silica glass crucible.

3. A process according to Claim 1 or Claim 2, wherein the layer of silica glass powder is a porous layer formed on the surface of the silica glass crucible by heating and sintering the silica glass powder at a temperature below the crystallisation temperature.

4. A process according to any preceding claim, further comprising the steps of forming the silica glass powder layer by:
(i) forming a slurry of silica glass powder,
(ii) coating said slurry on the surface of the silica glass crucible, and
(iii) solidifying the coated slurry.

5. A process according to Claim 4, wherein the slurry further comprises a binder.

6. A method for pulling a silicon single crystal comprising the steps of:
forming a silica glass powder layer on the whole or a part of the surface of a silica glass crucible, the silica glass powder comprising fine and coarse silica particles, wherein more than 20 weight % of all powder is the fine silica particles having a particle size of less than 10 µm, and the remaining powder is the coarse silica particles having a particle size of less than 150 µm, and
crystallising the silica glass powder layer on the surface of the crucible at high temperature at the time of melting the silicon raw material charged into the crucible to reinforce the silica glass crucible.

## Patentansprüche

1. Verfahren zur Verstärkung eines Silicaglastiegels, das die Schritte
des Ausbildens einer Schicht aus Silicaglaspulver, das feine und grobe Silicapartikel umfaßt, auf der gesamten oder einem Teil einer Oberfläche des Silicaglastiegels, wobei mehr als 20 Gew.% des gesamten Pulvers die feinen Silicapartikel mit einer Partikelgröße von weniger als 10 µm sind und das übrige Pulver die groben Silicapartikel mit einer Partikelgröße von weniger als 150 µm sind, und
des Kristallisierens der Silicaglaspulverschicht auf der Oberfläche des Tiegels bei hoher Temperatur, um den Silicaglastiegel zu verstärken, umfaßt.

2. Verfahren gemäß Anspruch 1, bei dem die hohe Temperatur der Schmelztemperatur des Siliziumrohmaterials entspricht, das in den Silicaglastiegel gegeben wird.

3. Verfahren gemäß Anspruch 1 oder 2, bei dem die Schicht des Silicaglaspulvers eine poröse Schicht ist, die auf der Oberfläche des Silicaglastiegels durch Erhitzen und Sintern des Silicaglaspulvers bei einer Temperatur unterhalb der Kristallisationstemperatur gebildet wird.

4. Verfahren gemäß mindestens einem der vorhergehenden Ansprüche, das ferner die Schritte des Ausbildens der Silicaglaspulverschicht durch:
(i) Ausbilden einer Aufschlämmung des Silicaglaspulvers,
(ii) Aufbringen dieser Aufschlämmung auf die Oberfläche des Silicaglastiegels und
(iii) Verfestigen der aufgebrachten Aufschlämmung
umfaßt.

5. Verfahren gemäß Anspruch 4, bei dem die Aufschlämmung ferner ein Bindemittel umfaßt.

6. Verfahren zum Ziehen eines Siliziumeinkristalls, das die Schritte
des Ausbildens einer Silicaglaspulverschicht auf der gesamten oder einem Teil der Oberfläche eines Silicaglastiegels, wobei das Silicaglaspulver feine und grobe Silicapartikel umfaßt, wobei mehr als 20 Gew.% des gesamten Pulvers die feinen Silicapartikel mit einer Partikelgröße von weniger als 10 µm und das übrige Pulver die groben Silicapartikel mit einer Partikelgröße von weniger als 150 µm sind, und
des Kristallisierens der Silicaglaspulverschicht auf der Oberfläche des Tiegels bei hoher Temperatur zum Zeitpunkt des Schmelzens des in den Tiegel gegebenen Siliziumausgangsmaterials, um den Silicaglastiegel zu verstärken, umfaßt.

## Revendications

1. Procédé pour renforcer un creuset en verre de silice comprenant les étapes de :
formation sur la totalité ou une partie d'une surface du creuset en verre de silice d'une couche de poudre de verre de silice comprenant des particules de silice fines et grossières, dans lequel plus de 20 % en poids de la totalité de la poudre est constitué par les particules de silice fines avec une taille de particule de moins de 10 µm, et la poudre restante est constituée par les particules de silice grossières avec une taille de particule de moins de 150 µm, et
cristallisation de la couche de poudre de verre de silice sur la surface du creuset à une température élevée pour renforcer le creuset en verre de silice.

2. Procédé selon la revendication 1, dans lequel la température élevée correspond à la température de fusion de la matière brute de silicium chargée dans le creuset en verre de silice.

3. Procédé selon la revendication 1 ou la revendication 2, dans lequel la couche de poudre de verre de silice est une couche poreuse formée sur la surface du creuset en verre de silice en chauffant et en frittant la poudre de verre de silice à une température au-dessous de la température de cristallisation.

4. Procédé selon l'une quelconque des revendications précédentes, comprenant en outre les étapes de formation de la couche de poudre de verre de silice par :
(i) la formation d'une bouillie de poudre de verre de silice,
(ii) le revêtement de ladite bouillie sur la surface du creuset en verre de silice, et
(iii) la solidification de la bouillie revêtue.

5. Procédé selon la revendication 4, dans lequel la bouillie comprend en outre un liant.

6. Procédé pour former un cristal unique de silicium comprenant les étapes de :
formation d'une couche de poudre de verre de silice sur la totalité ou une partie de la surface d'un creuset en verre de silice, la poudre de verre de silice comprenant des particules de silice fines et grossières, dans lequel plus de 20 % en poids de la totalité de la poudre est constitué par les particules de silice fines ayant une taille de particule de moins de 10 µm, et la poudre restante est constituée par les particules de silice grossières ayant une taille de particule de moins de 150 µm, et
cristallisation de la couche de poudre de verre de silice sur la surface du creuset à une température élevée au moment de la fusion de la matière brute de silicium chargée dans le creuset pour renforcer le creuset en verre de silice.
